# EUROPEAN PATENT APPLICATION

(11) **EP 4 006 991 A1**
(43) Date of publication of application: **01.06.2022**
(21) Application number: 19943513.2
(22) Date of filing: 04.11.2019
(51) Int. Cl.: H01L 29/778

(54) **TRANSISTOR HAVING HIGH WITHSTAND VOLTAGE AND HIGH ELECTRON MOBILITY AND PREPARATION METHOD THEREFOR**

(30) Priority: 30.08.2019 CN 201910826836
(71) Applicant: Guangdong Zhineng Technology Co., Ltd., Guangzhou, Guangdong 510700 (CN)
(72) Inventor: LI, Zilan, Guangzhou Guangdong 510700 (CN)
(74) Representative: Locas, Davide
(86) International application number: PCT/CN2019/115426
(87) International publication number: WO 2021/035946

(57) **Abstract**

A transistor having high withstand voltage and high electron mobility and a preparation method therefor. The transistor having high withstand voltage and high electron mobility comprises: gate electrodes (108), source electrodes (107), a drain electrode (106), a barrier layer (105), a channel layer (104), a nucleation layer (103), and a substrate (101). The channel layer (104) is located between the barrier layer (105) and the substrate (101). The channel layer (104) comprises a P-type III-V group semiconductor layer, wherein the projection of the nucleation layer (103) on the substrate (101) overlaps at least part of that of the drain electrode (106), the drain electrode (106) is in electrical contact with the two-dimensional electron gas of the channel layer (104), the source electrodes (107) are in electrical contact with the P-type III-V group semiconductor layer, and the gate electrodes (108) are located on the barrier layer (105).

## Description

### Cross-Reference to Related Applications

The present application claims the priority of the Chinese Patent Application No. 201910826836X, filed with the China Patent Office on August 30, 2019, and entitled as "transistor with high withstand voltage and high electron mobility", the entire contents of which are incorporated by reference in the present application.

### Technical Field

The present application relates to semiconductor power devices, in particular, to a transistor with high withstand voltage and high electron mobility and a preparation method therefor.

### Background Art

Group III-V compound semiconductors include at least one group III element and at least one group V element, comprising but not limited to gallium nitride (GaN), aluminum gallium nitride (AIGaN), gallium arsenide (GaAs), indium nitride aluminum gallium (InAIGaN) and indium gallium nitride (InGaN), etc. When the group V element is nitrogen (N), the group III-V compound semiconductor is also called as group III nitride semiconductor, that is, the group III nitride semiconductor comprises nitrogen and at least one group III element, and group III nitride semiconductors include, but are not limited to, GaN, AIGaN, InN, AIN, InGaN, InAIGaN, and the like.

A transistor with high electron mobility (HEMT) utilizes group III-V heterojunction structures, such as group III nitride heterojunction, to generate two-dimensional electron gas (2DEG) at the interface of group III nitride material where the heterojunction is formed, which allows the high density of current to pass therethrough and has relatively low resistance loss, and gradually realizes the withstand voltage capability being increased to 600V, even to 1200V. Conventional group III nitride transistor with high electron mobility is usually a depletion-mode device. Group III nitride transistor with high electron mobility needs to avoid the transistor with high electron mobility from being turned on in the situation of no gate voltage control, so as to protect the circuit and loads, due to the advantages of high breakdown voltage, high current density, and low on-resistance, etc. Therefore, it would be desirable to provide group III nitride transistor with high electron mobility which is normally off, or an enhancement mode transistor.

As such, it is needed to overcome the shortcomings and deficiencies in the prior art to manufacture a transistor with high withstand voltage and high electron mobility, and an enhancement mode group III-V transistor with high electron mobility.

In the related patent applications, we have proposed to realize normally-off devices through structures, such as P-type buried layers, and described the higher withstand voltage capability, and also described the structures of the related devices in detail. However, in the specific implementation process, when the selection area is subjected to the epitaxy, the nucleation area is located at the position of the source. This is mainly because the transistor with high electron mobility is of a symmetrical structure with respect to the source, with a gate electrode and a drain electrode located from the source to both sides. At the same time, the distance from the source electrode to the gate electrode is usually much smaller than the distance from the gate electrode to the drain electrode, and the lateral epitaxy from the source to the gate is much shorter than that from the drain to the gate, which is conducive to the realization of the fabrication accuracy of complex structures at the source and the gate through the epitaxy. At the same time, the voltage in the source region is quite low, and the crystal quality of the nucleation region is relatively poor, so that when the source is located in the low-quality region, the influence is minimal due to the voltage being low.

In contrast, due to the nucleation and the lateral epitaxy from the gate or other regions, the laterally epitaxial structures on both sides are basically symmetrical, which is not conducive to the formation of many asymmetric structures. Moreover, if the lateral epitaxy starts from the gate electrode region, then because the distance from gate to source and the distance from gate to drain are quite different, it is not conducive to the good use of the chip area.

However, the nucleation and the lateral epitaxy from the region corresponding to the projection of the drain region on the substrate can also be achieved. At this time, it is also beneficial to form some special structures in the drain region to improve the performance of a certain aspect. Meanwhile, the crystal quality of the epitaxial layer can be optimized before forming complex structures at the source and gate. In this way, the complex structure at the source and gate can also obtain better crystal quality and achieve good electrical characteristics. Regardless of whether the nucleation is formed from the source or the drain region, the required stacking layout structure can be formed sequentially from the source to the gate to the drain, or from the drain to the gate to the source.

### Summary

The basic principle of the present application is to adjust the electric field distribution of the high electron mobility transistor device and improve its withstand voltage capability and realize the enhancement mode device, by introducing the P-type group III-V semiconductor layer, by means of doping modulation technology.

The basic structure of the transistor with high electron mobility provided by the present application is to select a region to epitaxially grow the group III-V semiconductor layer from the region corresponding to the drain electrode; form the semiconductor layer regions with different doping concentrations through the modulation doping technology, and finally form a transistor structure with high electron mobility. In this way, the local high electric field of the channel layer is reduced, the electric field distribution is improved, and performance and reliability of the device are improved.

In the first aspect, the transistor with high withstand voltage and high electron mobility is provided by the present application, comprising device structures, such as a gate electrode, a source electrode, a drain electrode, a barrier layer, a channel layer, a nucleation layer, and a substrate, etc., wherein the channel layer comprising a P-type group III-V semiconductor layer is located between the barrier layer and the substrate; the P-type group III-V semiconductor layer is located at least partially between the drain electrode and the gate electrode, which is insufficient to significantly deplete the two-dimensional electron gas in the channel except for the gate electrode stack, wherein the nucleation layer corresponds to the drain electrode region, the drain electrode is in electrical contact with the channel layer above the nucleation layer, and the source electrode is in electrical contact with the P-type group III-V semiconductor layer.

Optionally, a low-doped or unintentionally doped group III-V semiconductor layer may be introduced between the barrier layer and the P-type group III-V semiconductor layer.

Optionally, a SiNx passivation layer may be grown in-situ on the barrier layer, and a gate dielectric layer is provided under the gate electrode.

Optionally, a gate dielectric layer may be formed on the barrier layer.

Optionally, a low-doped or unintentionally doped group III-V semiconductor layer may be introduced above the modulation P-type group III-V semiconductor layer.

Optionally, the barrier layer above the P-type group III-V semiconductor layer may further be covered by a passivation layer.

Optionally, the lightly doped group III-V semiconductor layer first doped region is lightly doped or not doped.

Optionally, the P-type group III-V semiconductor layer comprises modulation regions with different doping concentrations; and with the nucleation layer region as a center, a lightly doped group III-V semiconductor layer first doped region, the a strongly P-type group III-V semiconductor layer first doped region and a P-type group III-V semiconductor layer first doped region are provided sequentially outwards; and the drain electrode is formed above the lightly doped group III-V semiconductor layer first doped region, a gate electrode stack structure is correspondingly formed above the strongly P-type group III-V semiconductor layer first doped region, and the source electrode is formed above the P-type group III-V semiconductor layer first doped region.

Optionally, the strongly P-type group III-V semiconductor layer first doped region under the gate electrode can deplete more than 95% of the two-dimensional electron gas under stack of the gate electrode at 0 gate voltage, or concentration of the two-dimensional electron gas under the stake of the gate electrode at 0 gate voltage is made to be less than 5E11/cm².

Optionally, a doping concentration of the lightly doped group III-V semiconductor layer first doped region is less than 5E17/cm³.

Optionally, the P-type group III-V semiconductor layer comprises modulation regions with different doping concentrations; with the nucleation layer region as a center, a lightly doped group III-V semiconductor layer first doped region, a P-type group III-V semiconductor layer first doped region and a P-type group III-V semiconductor layer second doped region are provided sequentially outwards, the drain electrode is formed above the lightly doped group III-V semiconductor layer first doped region, and a gate electrode stack structure is formed at a part of the P-type group III-V semiconductor layer second doped region close to the P-type group III-V semiconductor layer first doped region, that is, the P-type group III-V semiconductor layer first doped region is located between the drain electrode and the gate electrode, and a doping concentration of the P-type group III-V semiconductor layer first doped region is adjustable, which can improve electric field distribution under the gate electrode, near a drain side, and the source electrode is formed above the P-type group III-V semiconductor layer second doped region.

Optionally, the P-type group III-V semiconductor layer comprises modulation regions with different doping concentrations; and with the nucleation layer region as a center, a lightly doped group III-V semiconductor layer first doped region, a P-type group III-V semiconductor layer first doped region, a strongly P-type group III-V semiconductor layer first doped region, and a P-type group III-V semiconductor layer second doped region are provided sequentially outwards; the drain electrode is provided above the lightly doped group III-V semiconductor layer first doped region, and a gate electrode stack structure is correspondingly formed above the strongly P-type group III-V semiconductor layer first doped region, the P-type group III-V semiconductor layer first doped region is located between the lightly doped group III-V semiconductor layer first doped region and the strongly P-type group III-V semiconductor layer first doped region, a doping concentration of the P-type group III-V semiconductor layer first doped region is adjustable, which can improve electric field distribution under the gate electrode, near a drain side, and the source electrode is formed above the P-type group III-V semiconductor layer second doped region.

Optionally, when the source electrode is in electrical contact with the P-type group III-V semiconductor layer, partial area of the source electrode is in contact with the two-dimensional electron gas and partial area of the source electrode is in direct contact with the P-type group III-V semiconductor layer, passing through the channel layer.

Optionally, when the source electrode is in electrical contact with the two-dimensional electron gas, metal material in contact with the P-type group III-V semiconductor layer is electrically connected to the source electrode, which facilitates being controlled together with a potential of the source electrode.

In the second aspect, the present application provides a transistor with high withstand voltage and high electron mobility, comprising a gate electrode, a source electrode, a drain electrode, a barrier layer, a channel layer, a nucleation layer, and a substrate, wherein a projection of the nucleation layer on the substrate and a projection of the drain electrode on the substrate at least partially overlap each other, the channel layer comprising the P-type group III-V semiconductor layer is located between the barrier layer and the substrate, which is not sufficient to significantly deplete two-dimensional electron gas in the channel except for a gate stack, and both the source electrode and the drain electrode are in electrical contact with two-dimensional electron gas, the gate electrode is located on the barrier layer, and an independent body electrode is in electrical contact with the P-type group III-V semiconductor layer, near the source electrode.

In the third aspect, the present application provides a method for preparing a transistor with high electron mobility mentioned above, comprising forming and growing a P-type group III-V semiconductor layer on the nucleation layer by lateral epitaxy; forming, on the P-type group III-V semiconductor layer, when lateral epitaxy growth, modulation-doped P-type group III-V semiconductor layer depending on different doping concentrations of different regions; and using a mixed atmosphere of precursors containing hydrogen and/or chlorine, when laterally epitaxially growing the P-type group III-V semiconductor layer.

Optionally, one insulating layer is provided on the substrate; after being subjected to masking, etching and other processes to form an opening, the insulating layer forms a nucleation layer at the opening, and then the epitaxial layer structure including the P-type group III-V semiconductor layer is grown in the lateral epitaxy manner; or one nucleation layer is grown on the substrate, and one insulating layer is formed on the nucleation layer; the insulating layer is subjected to masking, etching and other processes to form an opening to expose the nucleation layer, and then the epitaxial layer structure including the P-type group III-V semiconductor layer is grown by lateral epitaxy manner.

Optionally, an epitaxial layer structure is grown on the substrate in a lateral epitaxy manner; taking as a center the region where the drain electrode is located, it is expanded outward to form a symmetrical transistor structure with high electron mobility, with the drain electrode region as a center.

Optionally, when an epitaxial layer structure is grown on the substrate in lateral epitaxy manner, firstly, the lightly doped group III-V semiconductor layer first doped region, the strongly P-type group III-V semiconductor layer first doped region, the P-type group III-V semiconductor layer first doped region are epitaxially formed on the nucleation layer; a partial region in a height direction of the group III-V semiconductor layer is removed by a planarization or etching process to expose a modulation P-type group III-V semiconductor layer of the lightly doped group III-V semiconductor layer first doped region, the strongly P-type group III-V semiconductor layer first doped region, and the P-type group III-V semiconductor layer first doped region; and a drain electrode is formed above the lightly doped group III-V semiconductor layer first doped region, and a gate electrode stack structure is correspondingly formed above the strongly P-type group III-V semiconductor layer first doped region, and a source electrode is formed above the P-type group III-V semiconductor layer first doped region.

Optionally, when the epitaxial layer structure is grown on the substrate in lateral epitaxy manner, firstly, the lightly doped group III-V semiconductor layer first doped region is epitaxially formed on the nucleation layer, and then the P-type group III-V semiconductor layer first doped region and the P-type group III-V semiconductor layer second doped region are epitaxially formed, and a partial region in a height direction of the group III-V semiconductor layer is removed by a planarization or etching process to expose a modulation P-type group III-V semiconductor layer of the lightly doped group III-V semiconductor layer first doped region, the P-type group III-V semiconductor layer first doped region and the P-type group III-V semiconductor layer second doped region; the drain electrode is formed above the lightly doped group III-V semiconductor layer first doped region, and a gate electrode stack structure is formed in a part of the P-type group III-V semiconductor layer second doped region close to the P-type group III-V semiconductor layer first doped region, that is, the P-type group III-V semiconductor layer first doped region is located between the drain electrode and the gate electrode, and a doping concentration of the P-type group III-V semiconductor layer first doped region is adjustable, which can improve electric field distribution under the gate electrode, near a drain side, and the source electrode and/or a body electrode is formed above the P-type group III-V semiconductor layer second doped region.

Optionally, when an epitaxial layer structure is grown on the substrate in lateral epitaxy manner, firstly, the lightly doped group III-V semiconductor layer first doped region is epitaxially formed on the nucleation layer, and then the P-type group III-V semiconductor layer first doped region, the strongly P-type group III-V semiconductor layer first doped region, and the P-type group III-V semiconductor layer second doped region are epitaxially formed, a partial region in a height direction of the group III-V semiconductor layer is removed by a planarization or etching process, to expose a modulation P-type group III-V semiconductor layer of the lightly doped group III-V semiconductor layer first doped region, the P-type group III-V semiconductor layer first doped region, the strongly P-type group III-V semiconductor layer first doped region, and the P-type group III-V semiconductor layer second doped region; the drain electrode is formed above the lightly doped group III-V semiconductor layer first doped region, a gate electrode stack structure is correspondingly formed above the strongly P-type group III-V semiconductor layer first doped region, and the P-type group III-V semiconductor layer first doped region is located between the lightly doped group III-V semiconductor layer first doped region and the strongly P-type group III-V semiconductor layer first doped region, and a doping concentration of the P-type group III-V semiconductor layer first doped region is adjustable, which can improve electric field distribution under the gate electrode, near a drain side, and the source electrode and/or a body electrode is formed above the P-type group III-V semiconductor layer second doped region.

Optionally, a mixed atmosphere of precursors containing hydrogen and/or chlorine is used during a lateral epitaxial growth of a structure containing the P-type group III-V semiconductor layer.

As for the P-type group III-V semiconductor layer of the present application, the lateral epitaxial growth starts from the region corresponding to the drain electrode, and the P-type doping concentration can be adjusted by adjusting the proportion of the doped carrier gas atmosphere according to the needs in the growth process. The electric field distribution is adjusted by P-type doping, and high-quality P-type doping and its spatial adjustment to the two-dimensional electron gas 2DEG at the AIGaN/GaN heterojunction interface can be obtained; and by modulating the doping concentration of the semiconductor layer under the drain electrode, the gate electrode and the source electrode, the modulation of the potential of the P-type group III-V semiconductor layer can be controlled by the source electrode or the body electrode, which can improve the withstand voltage capability of the transistor with high electron mobility and realize functions, such as normally-off operation, etc.

### Brief Description of Drawings

In order to illustrate the technical solutions of the embodiments of the present application more clearly, the drawings that are used in the embodiments of the present application are briefly introduced as follows. It should be understood that the following drawings only show some embodiments of the present application, and therefore should not be regarded as a limitation to the scope. For those skilled in the art, other related drawings can also be obtained from these drawings without any creative efforts.
FIG. 1 shows a basic structure of a transistor with high withstand voltage and high electron mobility according to an embodiment of the present application;
FIG. 2-FIG. 4 are exemplary diagrams of the formation process of the transistor with high electron mobility provided by the embodiments of the present application;
FIG. 5 is an exemplary diagram of formation process of another transistor with high electron mobility provided by an embodiment of the present application; and
FIGS. 6-13 show several other complex transistors with high electron mobility and the formation processes provided by the embodiments of the present application.

### Detailed Description of Embodiments

The technical solutions in the embodiments of the present application will be described below with reference to the drawings in the embodiments of the present application.

It should be noted that similar reference numbers and letters refer to similar items in the following figures, so that once an item is defined in one figure, it is not required to further define and explain it in subsequent figures. Meanwhile, in the description of the present application, the terms "first", "second", etc. are only used to describe the distinguishing, and cannot be understood as indicating or implying importance of the relativity. "Up" and "down", etc. indicate a relative positional relationship, and do not indicate that the two are directly adjacent.

The basic idea of the transistor with high withstand voltage and high electron mobility of the present application is to start the lateral epitaxial growth from the region corresponding to the drain electrode. Since the selected region epitaxy can achieve higher crystal quality, which has certain advantages over the existing planar growth.

On the basis of the above basic structure, by doping and modulating the doping concentration in lateral epitaxy, the following structures and their combinations can be formed, wherein a strong P-type region is formed at the gate electrode stack, at which the two-dimensional electron gas is depleted, so as to achieve the device of normally-off enhancement mode; and in addition to forming a strong P-type region at the gate electrode stack, a P-type layer is formed near the source electrode, and the P-type layer does not significantly deplete two-dimensional electron gas between the source electrode and the gate electrode, but can connect with the strong P-type region at the gate electrode stack and connect to the electrode. The electrode can be a source electrode or a separate body electrode. A P-type region is formed between the gate electrode and the drain electrode, and the P-type region does not significantly deplete the two-dimensional electron gas but can improve the electric field distribution and reduce the maximum electric field strength.

In the transistor with high electron mobility of the present application, the doping concentration of strong doping is generally above 5E18/cm³, and the doping concentration of light doping is generally below 5E18/cm³. In transistor with high electron mobility, the strong doping or the light doping is relative and is related to the two-dimensional electron gas concentration at the channel layer/barrier layer interface. Generally, the higher the concentration of the intrinsic two-dimensional electron gas at the interface of the channel layer/barrier layer (in the absence of doping) is, the higher the doping concentration corresponding to the strong doping is, and the light doping can also have relatively higher doping concentration. On the contrary, the lower the intrinsic two-dimensional electron gas concentration is, the lower the doping concentration corresponding to the strong doping is, and therefore the light doping also has a relatively lower doping concentration.

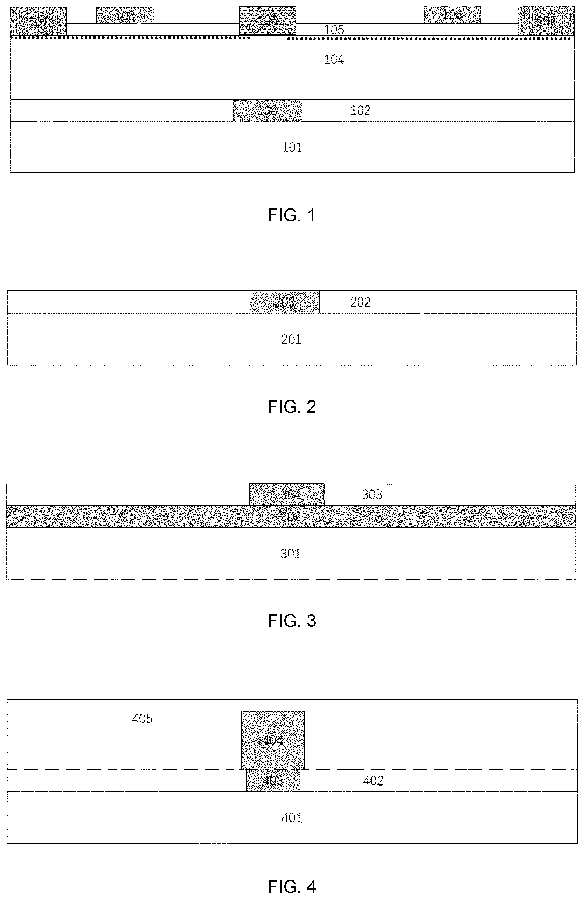

Referring to FIG. 1, FIG. 1 shows a basic structure of a transistor with high withstand voltage and high electron mobility according to an embodiment of the present application. In its basic structure, an insulating layer 102 and a nucleation layer 103 are on the substrate 101, and a channel layer 104 is on the insulating layer 102 and the nucleation layer 103; the channel layer 104 can be a P-type semiconductor layer, and more specifically, can be P-type group III-V semiconductor layer, the barrier layer 105 is on the P-type group III-V semiconductor layer, and two-dimensional electron gas 2DEG is formed at the heterojunction interface of the barrier layer 105 and the channel layer 104; the source electrode 107 and the drain electrode 106 are connected with the two-dimensional electron gas and form an ohmic contact, and the gate electrode 108 is located on the barrier layer 105, wherein the projections of the nucleation layer 103 and the drain electrode 106 on the substrate 101 are at least partially overlapped with each other, forming a transistor structure with high electron mobility with the drain electrode extending outward. The doping concentration of the P-type group III-V semiconductor layer is relatively low, and the P-type group III-V semiconductor layer will not seriously deplete the two-dimensional electron gas located at the interface between the barrier layer and the P-type group III-V semiconductor layer. There is still a relatively high concentration of two-dimensional electron gas at the heterojunction interface. Optionally, the group III-V semiconductor layer is generally a nitride semiconductor layer, and the P-type group III-V semiconductor layer is at least partially located under the two-dimensional electron gas region between the gate electrode and the drain electrode and between the gate electrode and the source electrode. Except for the gate electrode stack region, the P-type group III-V semiconductor layer depletes 80% of the channel 2DEG concentration when the channel 2DEG concentration is less than that of no the P-type group III-V semiconductor layer contained, that is, at least 20% of the two-dimensional electron gas is preserved. The P-type group III-V semiconductor layer in the region between the gate electrode and the drain electrode will also partially deplete under the action of the electric field, exposing the negative charges in the background. These negative charges can effectively cancel the influences of the positive charge at the channel and the positive charge of the drain electrode, adjust the distribution of the electric field, reduce the intensity of the local electric field peak, and improve the withstand voltage capability of the device.

In some possible embodiments, the transistor with high withstand voltage and high electron mobility provided by the embodiment of FIG. 1 can be formed through the steps shown in FIGS. 2-4 and the like. In a possible embodiment, as shown in FIG. 2, one insulating layer 202 is formed on the substrate 201, an opening region is formed on the insulating layer through processes such as masking and etching, and nucleation layer 203 is epitaxially grown at the opening region of the insulating layer, and then the P-type group III-V semiconductor layer is grown by the lateral epitaxy manner; or in a possible embodiment, as shown in FIG. 3, one nucleation layer 302 is epitaxially grown on the substrate 301, and then one insulating layer 303 is formed, and an opening region 304 is formed on the insulating layer through processes such as masking and etching to expose the nucleation layer 302, and then the P-type group III-V semiconductor layer is epitaxially grown on the nucleation layer at the opening region of the insulating layer by the lateral epitaxy manner.

It should be noted that with certain substrates (such as Al₂O₃ substrates) and under certain process conditions, the nucleation layer can be selectively grown on the exposed substrate but not on the insulating layer. However, when using a silicon substrate, it is usually necessary to use AIN as the nucleation layer, and however, when AIN is used as the nucleation layer, the growth selectivity is poor. At this time, the AIN on the insulating layer can be etched/removed after the nucleation layer is grown. However, under certain growth conditions, the deposition of AIN on the insulating layer is very small, and the nucleation growth matrix of the subsequent nitride epitaxy layer cannot be formed on the insulating layer. Except for the growth in the nucleation region, there is no obvious subsequent growth of the P-type group III-V semiconductor layer in other regions, so that the step of removing the AIN on the insulating layer can be omitted and the subsequent growth can be performed directly.

Alternatively, as the AIN on the insulating layer is polycrystalline or amorphous, nucleation and growth can be carried out only on the single crystal AIN in the opening region under appropriate process conditions, but not on the polycrystalline AIN on the insulating layer. At this time, the AIN layer of the polycrystalline structure plays an insulating role to a large extent.

In another possible embodiment, as shown in FIG. 4, one insulating layer 402 is formed on the substrate 401, and an opening region is formed on the insulating layer through processes such as masking and etching, etc., and the nucleation layer 403 is epitaxially grown at the opening region of the insulating layer; and the buffer layer 404 is formed first, and then the P-type group III-V semiconductor layer 405 with high crystal quality is formed as the channel layer.

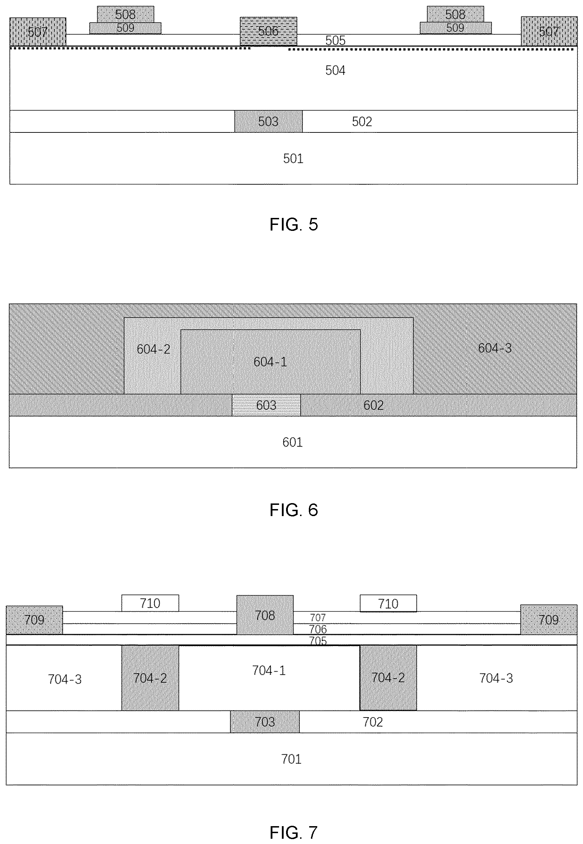

In another possible embodiment, as shown in FIG. 5, one insulating layer 502 is formed on the substrate 501, and an opening region is formed on the insulating layer through processes such as masking and etching, etc., and the nucleation layer 503 is epitaxially grown at the opening region of the insulating layer. After the P-type group III-V semiconductor layer 504 is formed and grown on the nucleation layer by lateral epitaxy, then one barrier layer 505 is formed, and then the SiNx passivation layer (not shown) is deposited in-situ in the same deposition equipment to obtain a barrier layer/SiNx layer with a low interface defect state density. As for the in-situ SiNx layer, after being subjected to the masking and etching process, it is possible to only keep the SiNx layer under the gate electrode 508 to be used as the gate dielectric layer 509, as shown in FIG 5, and that is, the channel layer, the barrier layer, and the in-situ SiNx layer are sequentially grown in the same growing equipment, which can improve the utilization rate of the equipment and the growth quality, and then the drain electrode 506 and the source electrode 507 are formed in the barrier layer, and the drain electrode 506 and the source electrode 507 are in ohmic contact with the two-dimensional electron gas. Finally, a transistor structure with high electron mobility as shown in FIG. 5 can be formed.

The transistor structure with high electron mobility shown in FIGS. 1 and 5 and in the following embodiments of the present application is a basic device structure for realizing a P-type group III-V semiconductor layer formed by lateral epitaxy on the corresponding region of the drain electrode and modulating the doping concentration. Optionally, in other embodiments, the transistor with high electron mobility may further include a low-doped or non-doped group III-V semiconductor layer such as the inserted P-GaN layer and the like, the cap layer, the field plate, the back barrier layer, and the additional electrode for controlling the electric field of the channel, etc., between the P-type group III-V semiconductor layer and the barrier layer; and there may be a gate dielectric layer and/or the p-GaN layer, etc. under the gate electrode, with the above structures or other structures disclosed in the prior art not excluded from the embodiments of the present application.

In another possible embodiment, as shown in FIG. 6-FIG. 9, one insulating layer 602-902 is formed on the substrate 601-901, and an opening region is formed on the insulating layer through processes such as masking and etching, etc. A nucleation layer 603-903 is epitaxially grown at the opening region of the insulating layer, and P-type group III-V semiconductor layer 604-904 is formed and grown on the nucleation layer by the lateral epitaxy.

In the specific implementation, as shown in Fig. 7, when the P-type group III-V semiconductor layer is grown epitaxially laterally, the doping modulation technique is used, and first, the lightly doped group III-V semiconductor layer first doped region (704-1) is formed on the nucleation layer through lateral epitaxy; and then the P-type layer-1 (704-2) is formed, wherein the P-type layer-1 (704-2) is a strong P-type group III-V semiconductor layer, which is beneficial to deplete the two-dimensional electron gas in the corresponding channel layer to realize a normally-off device; and then the group III-V semiconductor layer second doped region (704-3) is laterally epitaxially grown; and then part of the region in the height direction of the group III-V semiconductor layer is removed through the planarization or etching process to expose the modulation P-type group III-V semiconductor layer of the lightly doped group III-V semiconductor layer first doped region (704-1), the strong P-type group III-V semiconductor layer (704-2), and the group III-V semiconductor layer second doped region (704-3); and then the stack structure of the channel layer 705, the barrier layer 706 and the in-situ SiNx layer 707 is formed; and a source electrode 709, a drain electrode 708 and a gate electrode 710 are formed, wherein the gate electrode 710 corresponds to the strong P-type group III-V semiconductor layer region, and the source electrode 709 is substantially located above the group III-V semiconductor layer second doped region (704-3) and in ohmic contact with the two-dimensional electron gas, and the drain electrode is located above the lightly doped group III-V semiconductor layer first doped region (704-1) and in ohmic contact with the two-dimensional electron gas, and finally as shown in FIG. 7, the normally-off transistor structure with high withstand voltage and high electron mobility is formed.

Optionally, the strong P-type group III-V semiconductor layer disposed under the gate electrode can deplete more than 95% of the two-dimensional electron gas under the gate electrode stack at 0 gate voltage, or cause the concentration of the two-dimensional electron gas below the gate electrode stack at 0 gate voltage to be less than 5E11/cm².

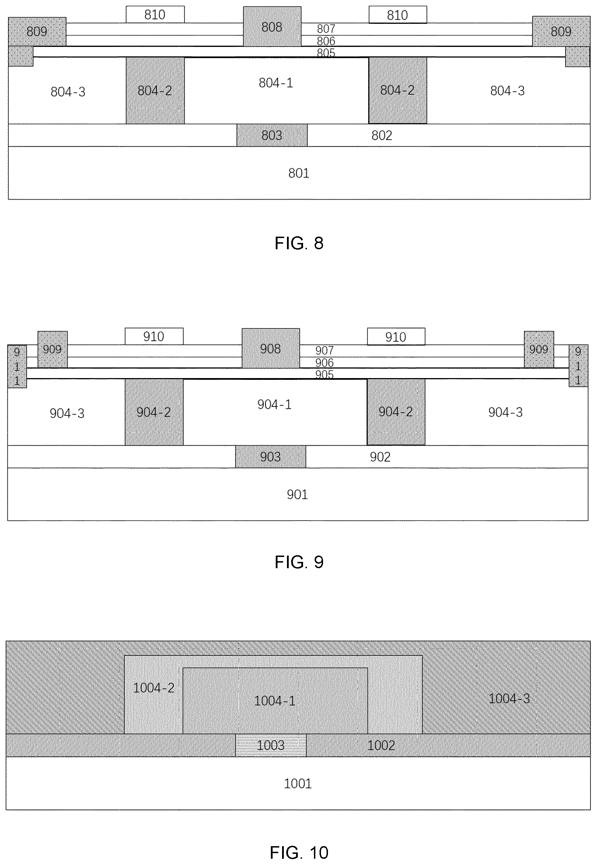

In addition, in order to strengthen the control of the source electrode on the group III-V semiconductor layer second doped region, then potential of the strong P-type group III-V semiconductor layer is controlled through this layer to obtain a stable threshold voltage of the transistor with high electron mobility, as shown in FIG. 8, when the group III-V semiconductor layer second doped region (804-3) is grown laterally epitaxially, a P-type doping growth is performed to form a P-type group III-V semiconductor layer, and finally the structure layer of the modulation P-type group III-V semiconductor layer 804 of the lightly doped group III-V semiconductor layer first doped region (804-1), the strong P-type group III-V semiconductor layer (804-2), the P-type group III-V semiconductor layer (804-3) are formed; the drain electrode 808 is located above the lightly doped group III-V semiconductor layer first doped region (804-1) and in ohmic contact with the two-dimensional electron gas; the P-type group III-V semiconductor layer (804-3) and the barrier layer 806 are exposed in a stepped manner through the processes, such as masking, etching, etc., and then the source electrode 809 is formed by deposition, so that the partial region of the source electrode 809 is connected with the two-dimensional electron gas; the partial region of the source electrode 809 is in direct contact with the P-type group III-V semiconductor layer 804-3, passing through the channel layer 805, wherein through the good electrical contact between the source electrode and the P-type group III-V semiconductor layer, the potential of the strong P-type group III-V semiconductor layer 804-2 can be controlled better to obtain a stable threshold voltage of the transistor with high electron mobility. Optionally, the part of the source electrode 809 in contact with the P-type group III-V semiconductor layer 804-3 is physically connected with the part of the source electrode 809 in contact with the two-dimensional electron gas (that is, they form in combination a source electrode); or the source electrode 809 is in contact with the two-dimensional electron gas, and the metal material in contact with the P-type group III-V semiconductor layer 804-3 is electrically connected to the source electrode 809, which facilitates controlling the potential of the source electrode together.

In addition, a gate dielectric layer 807 can also be provided. The gate dielectric layer can be in-situ SiNx or other dielectric materials such as SiO₂, high-k, etc., and is provided under the gate electrode 810 to completely cover the barrier layer 806.

The difference from the embodiment shown in FIG. 8 is that in the embodiment shown in FIG. 9, the electrode in contact with the P-type group III-V semiconductor layer 904-3 is one independent body electrode 911 not connected with the source electrode 909, the body electrode passes through the passivation layer, the barrier layer and the channel layer to be electrically connected to the P-type group III-V semiconductor layer 904-3 and the source electrode 909 is located above the channel layer, which is beneficial to the potential of the source electrode and the working potential of the P-type group III-V semiconductor layer 904-3 being independently controlled, and especially when the potential of the source is fixed at the zero potential point, the potential of the body electrode can be independently controlled according to the working voltage required to shut off the channel or stable working voltage, which is conducive to the stable and efficient operation of enhanced devices.

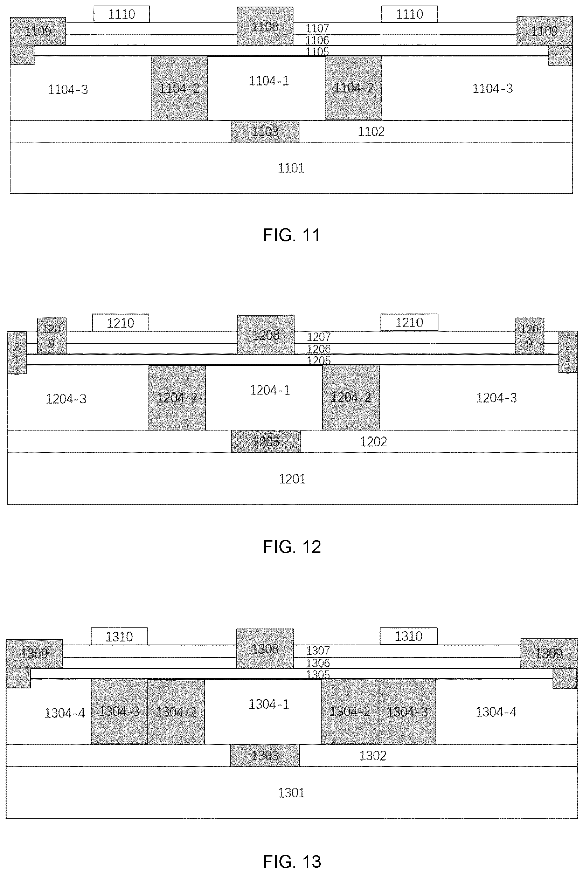

In another possible embodiment, as shown in FIG. 10, one insulating layer 1002 is formed on the substrate 1001, and an opening region is formed on the insulating layer through processes such as masking and etching, etc., and the nucleation layer 1003 is epitaxially grown at the opening region of the insulating layer. The P-type group III-V semiconductor layer 1004 is formed and grown on the nucleation layer by lateral epitaxy. The doping modulation technology is used when the P-type group III-V semiconductor layer is grown laterally epitaxially, firstly the lightly doped group III-V semiconductor layer first doped region (1004-1) is formed on the nucleation layer by lateral epitaxy; and then the P-type group III-V semiconductor layer first doped region (1004-2) is formed. The epitaxial growth time of the P-type group III-V semiconductor layer first doped region (1004-2) is shorter than that of the P-type group III-V semiconductor layer first doped region (604-2) shown in FIG. 6. The P-type group III-V semiconductor layer first doped region formed as shown in FIG. 10 is relatively narrow; then the P-type group III-V semiconductor layer second doped region (1004-3) is grown laterally epitaxially; then, a partial region in the height direction of the group III-V semiconductor layer is removed by a planarization or etching process, to expose the modulation P-type group III-V semiconductor layer of the lightly doped group III-V semiconductor layer first doped region (1004-1), the P-type group III-V semiconductor layer first doped region (1004-2), and the P-type group III-V semiconductor layer second doped region (1004-3); then, as shown in FIG. 11, stacked structure of a channel layer 1105, a barrier layer 1106, and an in-situ SiNx layer 1107 is formed; a source electrode 1109, a drain electrode 1108, and a gate electrode 1110 are formed, wherein the gate electrode 1110 deviates from the P-type group III-V semiconductor layer first doped region (1104-2) in the lateral direction; the drain electrode 1108 is substantially located on the channel layer 1105 above the lightly doped group III-V semiconductor layer first doped region (1104-1); the source electrode 1109 is in contact with the lightly doped group III-V semiconductor layer first doped region (the source electrode is formed in the same way as in the embodiment shown in FIG. 8), and finally, the transistor structure with high withstand voltage and high electron mobility shown in FIG. 11 is formed.

In the transistor with high withstand voltage and high electron mobility shown in FIG. 11, the drain electrode corresponds to the nucleation region, and the P-type group III-V semiconductor layer first doped region is located in the region between the gate electrode and the drain electrode, which can improve the high electric field distribution under the gate electrode, near the drain electrode region, preventing the device from failing due to excessive local electric field strength. It should be noted that the channel layer, the in-situ SiN passivation layer, and the gate insulating layer, etc., are optional but not necessary.

Optionally, as shown in FIG. 12, the electrode in contact with the P-type group III-V semiconductor layer second doped region is an independent body electrode, so as to facilitate the potential of the source electrode and the working potential of the P-type group III-V semiconductor layer being independently controlled, and especially when the potential of the source electrode is fixed at the zero potential point, it can be controlled independently according to the working voltage required to turn off the channel or stable working voltage.

The difference from the embodiment shown in FIG. 11 is that in the embodiment shown in FIG. 12, the electrode in contact with the P-type group III-V semiconductor layer 1204-3 is an independent body electrode 1211 that is not connected to the source electrode 1209, and the body electrode passes through the passivation layer, the barrier layer and the channel layer, to be electrically connected to the P-type group III-V semiconductor layer 1204-3. The source electrode 1209 is located above the channel layer, which is beneficial to the potential of the source electrode and the working potential of the P-type group III-V semiconductor layer 1204-3 being independently controlled, and especially when the potential of the source is fixed at the zero potential point, the potential of the body electrode can be independently controlled according to the working voltage required to turn off the channel or stable working voltage, which is conducive to the stable and efficient operation of the enhancement mode transistor with high electron mobility.

While reducing the drain electric field strength under the gate electrode and enhancing the withstand voltage capability of the transistor with high electron mobility, the transistor with high withstand voltage and high electron mobility shown in FIG. 11-FIG. 12 can be combined with the enhancement mode transistor structure with high electron mobility shown FIG.7-FIG. 9 through the doping modulation technology, to form an enhancement mode transistor with higher withstand voltage and high electron mobility shown in FIG. 13. As for the transistor with high electron mobility shown in FIG. 13, one insulating layer 1302 is formed on a substrate 1301, an opening region is formed on the insulating layer through processes such as masking and etching, etc., and the nucleation layer 1303 is grown epitaxially at the opening region of the insulating layer, and a P-type group III-V semiconductor layer 1304 is formed and grown on the nucleation layer by lateral epitaxy. During the laterally epitaxial growth of the P-type group III-V semiconductor layer, the doping modulation technology is used to sequentially grow the lightly doped group III-V semiconductor layer first doped region (1304-1), the P-type group III-V semiconductor layer first doped region (1304-2), the strong P-type group III-V semiconductor layer (1304-3), and the P-type group III-V semiconductor layer second doped region (1304-4); and the strong P-type group III-V semiconductor layer (1304-3) is located at the gate electrode stack and a normally-off type device is obtained by depleting part or all of the two-dimensional electron gas at the gate electrode stack.

The P-type group III-V semiconductor layer (1304-4) and the barrier layer 1306 are exposed in a stepped manner through processes, such as masking, etching, etc., and then the source electrode 1309 is formed by deposition, so that the partial region of the source electrode 1309 is in contact with the two-dimensional electron gas; the partial region of the source electrode 1309 passes through the channel layer 1305 to be in direct contact with the P-type group III-V semiconductor layer 804-3. The source electrode 1309 and the P-type group III-V semiconductor layer second doped region (1304-4) are in good electrical contact and the potential of the strong P-type group III-V semiconductor layer (1304-3) is controlled through the P-type group III-V semiconductor layer second doped region (1304-4) so as to obtain a stable threshold voltage. The P-type group III-V semiconductor layer first doped region (1304-2) is located in the region between the gate electrode 1310 and the drain electrode 1308, which can improve the high electric field distribution under the gate electrode and near the drain electrode region, avoiding the device failure caused by the local electric field strength being too large. It should be noted that the channel layer, the in-situ SiN passivation layer, and the gate insulating layer, etc. are optional but not necessary.

In addition, in another embodiment with a potential control method different from that in the embodiment shown in FIG. 13 , the electrode in contact with the P-type group III-V semiconductor layer second doped region is the independent body electrode (the connection method of the source electrode and the body electrode is the same as that shown in FIG. 12), in order to facilitate the independent control of the potential of the source electrode and the working potential of the P-type group III-V semiconductor layer second doped region, which is conducive to the stable and efficient operation of the enhancement mode device under the high voltage conditions.

The above descriptions are merely embodiments of the present application, and are not intended to limit the protection scope of the present application. For those skilled in the art, the present application may have various modifications and changes. Any modifications, equivalent replacements, improvements, etc. made within the spirit and principle of the present application shall be included within the protection scope of the present application.

### Industrial Applicability

By applying the technical solutions of the present application, high-quality P-type doping and its spatial adjustment to the two-dimensional electron gas 2DEG at the AIGaN/GaN heterojunction interface can be obtained, and the withstand voltage capability of the transistor with high electron mobility can also be improved, to realize functions, such as normally-off operations.

## Claims

1. A transistor with high withstand voltage and high electron mobility, **characterized by** comprising a gate electrode, a source electrode, a drain electrode, a barrier layer, a channel layer, a nucleation layer, and a substrate, wherein the channel layer comprising a P-type group III-V semiconductor layer is located between the barrier layer and the substrate, wherein a projection of the nucleation layer on the substrate and a projection of the drain electrode on the substrate at least partially overlap each other, the drain electrode is in electrical contact with two-dimensional electron gas of the channel layer, and the source electrode is in electrical contact with the P-type group III-V semiconductor layer, and the gate electrode is located on the barrier layer.

2. The transistor with high withstand voltage and high electron mobility according to claim 1, wherein a low-doped or unintentionally doped group III-V semiconductor layer is provided between the barrier layer and the P-type group III-V semiconductor layer.

3. The transistor with high withstand voltage and high electron mobility according to claim 1, wherein a SiNx passivation layer is formed by in-situ growth on the barrier layer, and a gate dielectric layer is provided under the gate electrode.

4. The transistor with high withstand voltage and high electron mobility according to claim 1, wherein the P-type group III-V semiconductor layer comprises modulation regions with different doping concentrations; and with a nucleation layer region as a center, a lightly doped group III-V semiconductor layer first doped region, the a strongly P-type group III-V semiconductor layer first doped region and a P-type group III-V semiconductor layer first doped region are provided sequentially outwards, wherein the drain electrode is formed above the lightly doped group III-V semiconductor layer first doped region, a gate electrode stack structure is correspondingly formed above the strongly P-type group III-V semiconductor layer first doped region, and the source electrode is formed above the P-type group III-V semiconductor layer first doped region.

5. The transistor with high withstand voltage and high electron mobility according to claim 4, wherein the strongly P-type group III-V semiconductor layer first doped region under the gate electrode can deplete more than 95% of two-dimensional electron gas under stack of the gate electrode at 0 gate voltage, or a concentration of the two-dimensional electron gas under the stake of the gate electrode at 0 gate voltage is made to be less than 5E11/cm².

6. The transistor with high withstand voltage and high electron mobility according to claim 4, wherein a doping concentration of the lightly doped group III-V semiconductor layer first doped region is less than 5E17/cm³.

7. The transistor with high withstand voltage and high electron mobility according to claim 1, wherein the P-type group III-V semiconductor layer comprises modulation regions with different doping concentrations; and with a nucleation layer region as a center, a lightly doped group III-V semiconductor layer first doped region, a P-type group III-V semiconductor layer first doped region and a P-type group III-V semiconductor layer second doped region are provided sequentially outwards, wherein the drain electrode is formed above the lightly doped group III-V semiconductor layer first doped region, and a gate electrode stack structure is formed at a part of the P-type group III-V semiconductor layer second doped region close to the P-type group III-V semiconductor layer first doped region, that is, the P-type group III-V semiconductor layer first doped region is located between the drain electrode and the gate electrode, and a doping concentration of the P-type group III-V semiconductor layer first doped region is adjustable, which can improve electric field distribution under the gate electrode, near a drain side, and the source electrode is formed above the P-type group III-V semiconductor layer second doped region.

8. The transistor with high withstand voltage and high electron mobility according to claim 1, wherein the P-type group III-V semiconductor layer comprises modulation regions with different doping concentrations; and with a nucleation layer region as a center, a lightly doped group III-V semiconductor layer first doped region, a P-type group III-V semiconductor layer first doped region, a strongly P-type group III-V semiconductor layer first doped region, and a P-type group III-V semiconductor layer second doped region are provided sequentially outwards, wherein the drain electrode is provided above the lightly doped group III-V semiconductor layer first doped region, and a gate electrode stack structure is correspondingly formed above the strongly P-type group III-V semiconductor layer first doped region, the P-type group III-V semiconductor layer first doped region is located between the lightly doped group III-V semiconductor layer first doped region and the strongly P-type group III-V semiconductor layer first doped region, a doping concentration of the P-type group III-V semiconductor layer first doped region is adjustable, which can improve electric field distribution under the gate electrode, near a drain side, and the source electrode is formed above the P-type group III-V semiconductor layer second doped region.

9. The transistor with high withstand voltage and high electron mobility according to claim 1, wherein when the source electrode is in electrical contact with the P-type group III-V semiconductor layer, partial area of the source electrode is in contact with the two-dimensional electron gas and partial area of the source electrode is in direct contact with the P-type group III-V semiconductor layer, passing through the channel layer.

10. The transistor with high withstand voltage and high electron mobility according to claim 1, wherein when the source electrode is in electrical contact with the two-dimensional electron gas, a metal material in contact with the P-type group III-V semiconductor layer is electrically connected to the source electrode, which facilitates controlling a potential of the source electrode together.

11. A transistor with high withstand voltage and high electron mobility, **characterized by** comprising a gate electrode, a source electrode, a drain electrode, a barrier layer, a channel layer, a nucleation layer, and a substrate, wherein a projection of the nucleation layer on the substrate and a projection of the drain electrode on the substrate at least partially overlap each other, the channel layer comprising a P-type group III-V semiconductor layer is located between the barrier layer and the substrate, which is not sufficient to significantly deplete two-dimensional electron gas in channel except for a gate stack, and both the source electrode and the drain electrode are in electrical contact with two-dimensional electron gas, the gate electrode is located on the barrier layer, and an independent body electrode is in electrical contact with the P-type group III-V semiconductor layer, near the source electrode.

12. A method for preparing the transistor with high withstand voltage and high electron mobility according to claim 1 or claim 11, **characterized in that** the P-type group III-V semiconductor layer is formed and grown on the nucleation layer by lateral epitaxy, the P-type group III-V semiconductor layer, when growing by lateral epitaxy, forms modulation-doped P-type group III-V semiconductor layer depending on different doping concentrations of different regions; and when laterally epitaxially growing the P-type group III-V semiconductor layer, a mixed atmosphere of precursors containing hydrogen and/or chlorine is used.

13. The method according to claim 12, wherein a method of forming a nucleation layer opening on the substrate is to grow one nucleation layer on the substrate, form one insulating layer on the nucleation layer, and make the insulating layer form an opening to expose the nucleation layer by processing including masking and etching; and then grow an epitaxial layer structure comprising the P-type group III-V semiconductor layer in lateral epitaxy manner.

14. The method according to claim 12, wherein, from the nucleation layer at the opening on the substrate, an epitaxial layer is grown in a lateral epitaxy manner; and with a projection area of the drain electrode on the substrate as a center, the epitaxial layer is expanded outward to form a symmetric transistor structure with high electron mobility, with a drain electrode region as a center.

15. The method according to claim 12, wherein when an epitaxial layer structure is grown on the substrate in lateral epitaxy manner, firstly, a lightly doped group III-V semiconductor layer first doped region, a strongly P-type group III-V semiconductor layer first doped region and a P-type group III-V semiconductor layer first doped region are epitaxially formed on the nucleation layer; a partial region in a height direction of the group III-V semiconductor layer is removed by a planarization or etching process to expose a modulation P-type group III-V semiconductor layer of the lightly doped group III-V semiconductor layer first doped region, the strongly P-type group III-V semiconductor layer first doped region, and the P-type group III-V semiconductor layer first doped region; and the drain electrode is formed above the lightly doped group III-V semiconductor layer first doped region, and a gate electrode stack structure is correspondingly formed above the strongly P-type group III-V semiconductor layer first doped region, and the source electrode is formed above the P-type group III-V semiconductor layer first doped region.

16. The method according to claim 12, wherein when a epitaxial layer structure is grown on the substrate in lateral epitaxy manner, firstly, a lightly doped group III-V semiconductor layer first doped region is epitaxially formed on the nucleation layer, and then a P-type group III-V semiconductor layer first doped region and a P-type group III-V semiconductor layer second doped region are epitaxially formed, and a partial region in a height direction of the group III-V semiconductor layer is removed by a planarization or etching process to expose a modulation P-type group III-V semiconductor layer of the lightly doped group III-V semiconductor layer first doped region, the P-type group III-V semiconductor layer first doped region and the P-type group III-V semiconductor layer second doped region; the drain electrode is formed above the lightly doped group III-V semiconductor layer first doped region, and a gate electrode stack structure is formed in a part of the P-type group III-V semiconductor layer second doped region close to the P-type group III-V semiconductor layer first doped region, that is, the P-type group III-V semiconductor layer first doped region is located between the drain electrode and the gate electrode, and a doping concentration of the P-type group III-V semiconductor layer first doped region is adjustable, which can improve electric field distribution under the gate electrode, near a drain side, and the source electrode is formed above the P-type group III-V semiconductor layer second doped region.

17. The method according to claim 12, wherein when an epitaxial layer structure is grown on the substrate in lateral epitaxy manner, firstly, a lightly doped group III-V semiconductor layer first doped region is epitaxially formed on the nucleation layer, and then a P-type group III-V semiconductor layer first doped region, a strongly P-type group III-V semiconductor layer first doped region, and a P-type group III-V semiconductor layer second doped region are epitaxially formed, and a partial region in a height direction of the group III-V semiconductor layer is removed by a planarization or etching process, to expose a modulation P-type group III-V semiconductor layer of the lightly doped group III-V semiconductor layer first doped region, the P-type group III-V semiconductor layer first doped region, the strongly P-type group III-V semiconductor layer first doped region, and the P-type group III-V semiconductor layer second doped region; and the drain electrode is formed above the lightly doped group III-V semiconductor layer first doped region, a gate electrode stack structure is correspondingly formed above the strongly P-type group III-V semiconductor layer first doped region, and the P-type group III-V semiconductor layer first doped region is located between the lightly doped group III-V semiconductor layer first doped region and the strongly P-type group III-V semiconductor layer first doped region, and a doping concentration of the P-type group III-V semiconductor layer first doped region is adjustable, which can improve electric field distribution under the gate electrode, near a drain side, and the source electrode is formed above the P-type group III-V semiconductor layer second doped region.

18. The method according to any one of claims 15-17, wherein a mixed atmosphere of precursors containing hydrogen and/or chlorine is used during a laterally epitaxial growth of a structure containing the P-type group III-V semiconductor layer.
